# EUROPEAN PATENT APPLICATION

(11) **EP 4 651 191 A1**
(43) Date of publication of application: **19.11.2025**
(21) Application number: 24861304.4
(22) Date of filing: 11.06.2024
(51) Int. Cl.: H01L 21/67

(54) **SCRUBBER FOR SEMICONDUCTOR EQUIPMENT**

(30) Priority: 05.04.2024 KR 20240046542
(71) Applicant: Oh, Seung Hwan, Seongbuk-gu Seoul 02822 (KR)
(72) Inventor: Oh, Seung Hwan, Seongbuk-gu Seoul 02822 (KR)
(74) Representative: Kim Kang, Jae Hee
(86) International application number: PCT/KR2024/007963
(87) International publication number: WO 2025/211494

(57) **Abstract**

The present invention relates to a scrubber for semiconductor apparatus that can effectively scrub a gas generated after performing a semiconductor process. The scrubber for semiconductor apparatus comprises an absorption tower separating the gas mixture into a first gas and a second gas, a housing defining a first scrubbing space in the absorption tower where a first scrubbing process is performed, a first tray connected to a first inner side wall of the housing, and extending a first direction intersecting the first inner side wall, a first tray hole penetrating the first tray in a second direction intersecting the first direction, and through which the gas mixture passes, and a solution supply nozzle providing a first scrubbing solution for performing the first scrubbing process to an upper surface of the first tray, wherein the gas mixture passes through the first tray hole and rises in the second direction.

## Description

### TECHNICAL FIELD

The present invention relates to a scrubber for semiconductor apparatus. Specifically, the present invention relates to the scrubber for semiconductor apparatus that improves scrubbing efficiency by increasing a contact area between a scrubbing solution and a gas.

### BACKGROUND ART

Many kinds of air pollutants are generated in modern industries. In particular, various chemicals are used in the process of manufacturing semiconductor devices. Many of these have very low human permissible concentrations. Therefore, it is very important to remove and discharge air pollutants from the gas emitted in the semiconductor industry.

Currently used air pollution prevention facilities include dust collectors and scrubbers, and they are installed considering their efficiency depending on the type of pollutant. Among these, scrubbers are widely used because they can simultaneously process dust, exhaust gas, and high-temperature gas.

Specifically, scrubbers are classified into dry, wet, and plasma types depending on the method of treating the exhaust gas, and wet scrubbers are used in a process that causes the exhaust gas to come into contact with a liquid to dissolve water-soluble components in the gas into the liquid.

In wet scrubbers, a cleaning solution is generally used to effectively remove harmful components of the exhaust gas. When the cleaning solution comes into contact with harmful components, it removes the harmful components through a chemical reaction such as neutralization, so the one that best reacts chemically with the harmful components of the emitted gas should be selected. The performance of the wet scrubber is determined by whether the solution containing the cleaning solution can efficiently contact the exhaust gas. Therefore, in the past, a filler was installed so that the solution containing the cleaning solution, and the exhaust gas could sufficiently come into contact, and a spray nozzle was installed to supply water with small particles.

Recently, a technology that can improve the contact area between the scrubbing solution containing the cleaning solution and the exhaust gas has been studied.

### DESCRIPTION OF EMBODIMENTS

### TECHNICAL PROBLEM

The technical problem that the present invention is trying to solve is to provide a semiconductor apparatus scrubber that improves the scrubbing efficiency by improving the contact area between the scrubbing solution and the gas.

The problems that the present invention is trying to solve are not limited to the problems mentioned above, and other problems that are not mentioned can be clearly understood by those skilled in the art from the description below.

### SOLUTION TO PROBLEM

According to some embodiments of the present invention for achieving the technical problem, the scrubber for semiconductor apparatus may scrub the gas mixture provided from a semiconductor chamber where a semiconductor process is performed. The scrubber for semiconductor apparatus comprises an absorption tower separating the gas mixture into a first gas and a second gas, a housing defining a first scrubbing space in the absorption tower where a first scrubbing process is performed, a first tray connected to a first inner side wall of the housing, and extending a first direction intersecting the first inner side wall, a first tray hole penetrating the first tray in a second direction intersecting the first direction, and through which the gas mixture passes, and a solution supply nozzle providing a first scrubbing solution for performing the first scrubbing process to an upper surface of the first tray, wherein the gas mixture passes through the first tray hole and rises in the second direction.

In some embodiments, wherein the first scrubbing process comprises the gas mixture passing through the first tray hole and rising in the second direction to generate bubbles, and at a surface where the bubbles come into contact with the first scrubbing solution, at least a portion of the first gas is dissolved into the first scrubbing solution.

By generating the bubbles in the scrubbing solution, the contact area between the gas and the scrubbing solution may be increased. Therefore, the efficiency of the scrubbing process may be improved.

The scrubber for semiconductor apparatus according to some embodiments further comprises a first pipe having one end connected to the semiconductor chamber and the other end connected to the absorption tower, a gas inlet port connected to the first pipe and through which the gas mixture is injected into the interior of the absorption tower, a gas outlet port connected to the absorption tower and through which the gas mixture is discharged to the exterior of the absorption tower, a second scrubbing space defined by a first inner side wall of the absorption tower and an outer side wall of the housing facing the first inner side wall of the absorption tower, and a first shower head installed in an upper part of the second scrubbing space and supplying a second scrubbing solution to the second scrubbing space, wherein one end of the second scrubbing space is connected to the gas inlet port, and the other end of the second scrubbing space is connected to the first scrubbing space.

In some embodiments, wherein the gas outlet port is connected to the first scrubbing space, and wherein a negative pressure is provided to the first scrubbing space through the gas outlet port.

In some embodiments, wherein the first scrubbing space and the second scrubbing space are connected to each other at a lower part of the absorption tower, wherein a second scrubbing process is performed in the second scrubbing space, and wherein the second scrubbing process comprises dissolving at least a portion of the first gas by the second scrubbing solution while the gas mixture is injected into the gas inlet port and flows in the second direction in the second scrubbing space.

The scrubber for semiconductor apparatus according to some embodiments further comprises a third scrubbing space defined by a second inner side wall of the absorption tower intersecting the first inner side wall of the absorption tower and a second outer side wall of the housing facing the second inner side wall of the absorption tower, and a second shower head installed in an upper part of the third scrubbing space and supplying a third scrubbing solution to the third scrubbing space.

The scrubber for semiconductor apparatus according to some embodiments further comprises a fourth scrubbing space defined by a third inner side wall of the absorption tower and a third outer side wall of the housing facing the third inner side wall of the absorption tower, and a third shower head installed in an upper part of the fourth scrubbing space and supplying a fourth scrubbing solution to the third scrubbing space, wherein the first inner side wall of the absorption tower connects the second inner side wall of the absorption tower and the third inner side wall of the absorption tower to each other.

The scrubber for semiconductor apparatus according to some embodiments further comprises a second tray connected to a second inner side wall of the housing, extending in the first direction, and spaced apart from the first tray in the second direction, and a second tray hole penetrating the second tray in the second direction, and through which the gas mixture passes, wherein the second inner side wall of the housing faces the first inner side wall of the housing, and wherein the gas mixture rises by passing through the second tray hole.

The scrubber for semiconductor apparatus according to some embodiments further comprises a first tray wall connected to one end of the first tray and protruding in the second direction from an upper surface of the first tray and a lower surface of the first tray, wherein the first tray wall comprises a first portion protruding from the upper surface of the first tray, and wherein the first scrubbing solution flows from the upper surface of the first tray to the protruding portion, and flows toward a lower part of the absorption tower over the protruding portion.

In some embodiments, wherein at least a portion of the first gas is dissolved in the first scrubbing solution, and wherein the first gas contains a hydrophilic gas.

Specific details of other embodiments are included in the specification and drawings.

### EFFECT OF INVENTION

The scrubber for semiconductor apparatus of the present invention comprises at least one tray. A tray hole is formed inside the tray, penetrating the tray. As gas passes through the tray hole, bubbles may be formed in a scrubbing solution disposed on an upper surface of the tray. As the bubbles are formed, the contact area between the scrubbing solution and the gas is increased, and since the contact area is increased, a hydrophilic gas among the gas may be dissolved more in the scrubbing solution. Accordingly, the gas from which contaminants have been removed may be discharged to the exterior of the scrubber for the semiconductor apparatus.

### BRIEF DESCRIPTION OF DRAWINGS

FIG. 1 is a drawing briefly explaining a semiconductor apparatus system including a scrubber for semiconductor apparatus according to some embodiments of the present invention.
FIG. 2 is an exemplary perspective view for explaining the scrubber for semiconductor apparatus of FIG. 1.
FIG. 3 is an exemplary cross-sectional view for explaining the scrubber for semiconductor apparatus of FIG. 1.
FIG. 4 is an exemplary plan view for explaining the scrubber for semiconductor apparatus of FIG. 1.
FIG. 5 is an enlarged view of the P area of FIG. 3.
FIGS. 6 to 11 are drawings for explaining the scrubber for semiconductor apparatus according to some other embodiments of the present invention.
FIGS. 12 and 13 are drawings for explaining an operating method of the scrubber for semiconductor apparatus according to some embodiments of the present invention.

### MODE OF INVENTION

Hereinafter, preferred embodiments of the present invention will be described in detail with reference to the accompanying drawings. The advantages and features of the present invention and the methods for achieving them will become apparent with reference to the embodiments described in detail below together with the accompanying drawings. However, the present invention is not limited to the embodiments described below, but may be implemented in various different forms, and these embodiments are provided only to make the invention of the present invention complete and to fully inform those skilled in the art of the scope of the invention, and the present invention is defined only by the scope of the claims. Like reference numerals refer to like elements throughout the specification.

In addition, the terminology used herein is for the purpose of describing embodiments, and is not intended to limit and/or restrict the disclosed invention. The singular expression includes the plural expression unless the context clearly indicates otherwise. In this specification, the terms "comprises", "include", or "has" and the like are intended to specify that a feature, number, step, operation, component, part, or combination thereof described in the specification is present, but do not exclude in advance the possibility of the presence or addition of one or more other features, numbers, steps, operations, components, parts, or combinations thereof.

In addition, terms including ordinal numbers such as "first", "second", etc. used in this specification may be used to describe various components, but the components are not limited by the terms, and the terms are used only for the purpose of distinguishing one component from another. For example, without departing from the scope of the present invention, the first component may be named the second component, and similarly, the second component may also be named the first component. The term "and/or" includes a combination of multiple related described items or any item among multiple related described items.

Meanwhile, the terms "front", "rear", "upper", "lower", "front", and "lower" used in the following description are defined based on the drawings, and the shape and position of each component are not limited by these terms.

The terms used in this specification are for describing embodiments and are not intended to limit the present invention. In this specification, the singular includes the plural unless specifically stated in the phrase. The terms "comprise" and/or "comprising" used in the specification do not exclude the presence or addition of one or more other components, steps, operations, and/or elements mentioned.

Unless otherwise defined, all terms (including technical and scientific terms) used in this specification may be used in a meaning that can be commonly understood by a person of ordinary skill in the art to which the present invention belongs. In addition, terms defined in commonly used dictionaries shall not be ideally or excessively interpreted unless explicitly specifically defined.

Hereinafter, embodiments of the present invention will be described in detail with reference to the attached drawings, and when describing with reference to the attached drawings, identical or corresponding components will be given the same reference numerals regardless of the drawing numbers, and redundant descriptions thereof will be omitted.

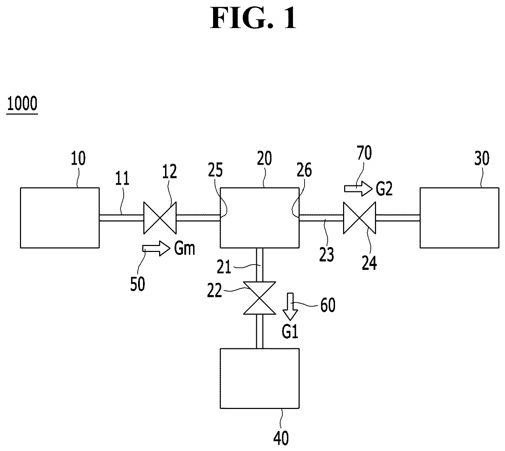

Hereinafter, first, a semiconductor apparatus system including a scrubber for semiconductor apparatus according to some embodiments of the present invention will be described with reference to FIG. 1. FIG. 1 is a drawing briefly explaining a semiconductor apparatus system including a scrubber for semiconductor apparatus according to some embodiments of the present invention.

Referring to FIG. 1, a semiconductor apparatus system 1000 according to some embodiments of the present invention may include a semiconductor chamber 10, a scrubber 20 for semiconductor apparatus, an exhaust gas discharge chamber 30, and a scrubbing solution discharge chamber 40.

The semiconductor chamber 10 may be a chamber in which a semiconductor process is performed. In order to manufacture a semiconductor device, various semiconductor processes must be performed on a wafer. For example, a film must be deposited on the wafer(deposition process), and the film must be etched (etching process) to form a pattern included in the semiconductor device. In addition, after the deposition process and/or the etching process are performed, a cleaning process must be performed to clean the wafer and/or the semiconductor chamber 10.

The deposition process may include, for example, physical vapor deposition (PVD), chemical vapor deposition (CVD), and/or atomic layer deposition (ALD). The etching process may include, for example, a dry etching process, a wet etching process, and/or an ashing process. The cleaning process may include, for example, a wet cleaning process, a dry cleaning process, and/or a vapor cleaning process.

In another embodiment, the deposition process, the etching process and/or the cleaning process may be performed simultaneously.

When the semiconductor process is performed in the semiconductor chamber 10, various by-products may be generated. The by-products may include substances harmful to the human body, and if the by-products include substances harmful to the human body, they must be removed and discharged. The scrubber 20 for semiconductor apparatus may be used to remove substances harmful to the human body and the by-products generated in the semiconductor chamber 10.

A first pipe 11 may be disposed between the semiconductor chamber 10 and the scrubber 20 for semiconductor apparatus. One end of the first pipe 11 may be connected to the semiconductor chamber 10, and the other end of the first pipe 11 may be connected to the scrubber 20 for semiconductor apparatus. A gas mixture Gm discharged from the semiconductor chamber 10 may be provided to the scrubber 20 for semiconductor apparatus through the first pipe 11 (see reference numeral 50).

In some embodiments, a first valve 12 may be connected to the first pipe 11. The first valve 12 may control the pressure and flow rate of the gas mixture Gm provided to the scrubber 20 for semiconductor apparatus through the first pipe 11.

The scrubber 20 for semiconductor apparatus may scrub the gas mixture Gm provided from the semiconductor chamber 10 in which the semiconductor proves is performed. For example, the gas mixture Gm may include a first gas G1 and a second gas G2. The first gas G1 may include a substance harmful to the human body, and the second gas G2 may not include a substance harmful to the human body. For example, the first gas G1 may be IPA (isopropyl alcohol) and/or ammonia. The scrubber 20 for semiconductor apparatus may separate the first gas G1 and the second gas G2 from the gas mixture Gm.

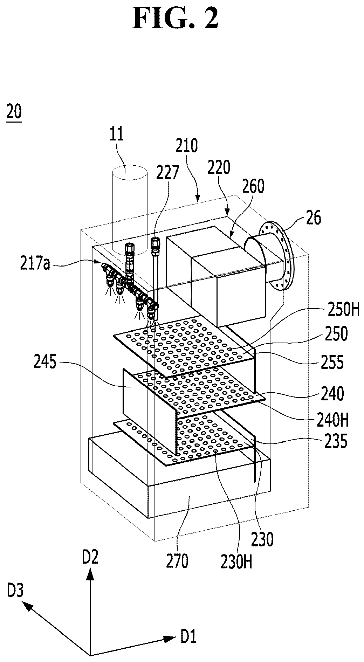

The first gas G1 may be dissolved in a scrubbing solution and stored in the scrubbing solution discharge chamber 40. The second gas G2 may be stored in the exhaust gas discharge chamber 30. A detailed description of the scrubber 20 for semiconductor apparatus will be described later using FIGS. 2 to 12.

The scrubbing solution discharge chamber 40 may be connected to the scrubber 20 for semiconductor apparatus. The scrubbing solution discharge chamber 40 and the scrubber 20 for semiconductor apparatus may be connected to each other through a second pipe 21. One end of the second pipe 21 may be connected to the scrubber 20 for semiconductor apparatus, and the other end of the second pipe 21 may be connected the scrubbing solution discharge chamber 40. The scrubbing solution in which the first gas G1 is dissolved may move from the scrubber 20 for semiconductor apparatus to the scrubbing solution discharge chamber 40 through the second pipe 21(see reference numeral 60).

In some embodiments, a second valve 22 may be connected to the second pipe 21. The second valve 22 may control the pressure and flow rate of the scrubbing solution containing the first gas G1 dissolved therein provide to the scrubbing solution discharge chamber 40 through the second pipe 21.

The exhaust gas discharge chamber 30 may be connected to the scrubber 20 for semiconductor apparatus. The exhaust gas discharge chamber 30 and the scrubber 20 for semiconductor apparatus may be connected to each other through a third pipe 23. One end of the third pipe 23 may be connected to the scrubber 20 for semiconductor apparatus, and the other end of the third pipe 23 may be connected to the exhaust gas discharge chamber 30. The second gas G2 may move from the scrubber 20 for semiconductor apparatus to the exhaust gas discharge chamber 30 through the third pipe 23(see reference numeral 70). The second gas G2 may be a gas from which a first gas G1 is removed from the gas mixture Gm.

In some embodiments, a third valve 24 may be connected to the third pipe 23. The third valve 24 may control the pressure and flow rate of the second gas G2 provided to the exhaust gas discharge chamber 30 through the third pipe 23.

In some embodiments, the scrubber 20 for semiconductor apparatus may further include a gas inlet port 25 and a gas outlet port 26. The gas mixture Gm may be injected into the scrubber 20 for semiconductor apparatus through the gas inlet port 25. The second gas G2 may be discharged to the exterior of the scrubber 20 for semiconductor apparatus through the gas outlet port 26. In FIG. 1, only the second gas G2 is shown to be discharged through the gas outlet port 26, but the technical idea of the present invention is not limited thereto. Of course, part of the first gas G1 may be included in the gas discharged to the exterior of the scrubber 20 for semiconductor apparatus.

Although no shown, the scrubber 20 according to some embodiments of the present invention may be utilized in various industrial fields. For example, the scrubber 20 according to some embodiments of the present invention may be utilized in the plant field, the battery field, the thermal power plant field, the steel field, and/or the chemical field. Preferably, the scrubber 20 according to some embodiments of the present invention may be utilized in the oil and gas plant industry.

When the scrubber 20 according to some embodiments of the present invention is utilized in the industrial field, pollutants generated after the process can be effectively separated and removed. Accordingly, environmental pollution problems can be reduced.

Hereinafter, a scrubber for semiconductor apparatus according to some embodiments of the present invention will be described in detail with reference to FIGS. 2 to 5.

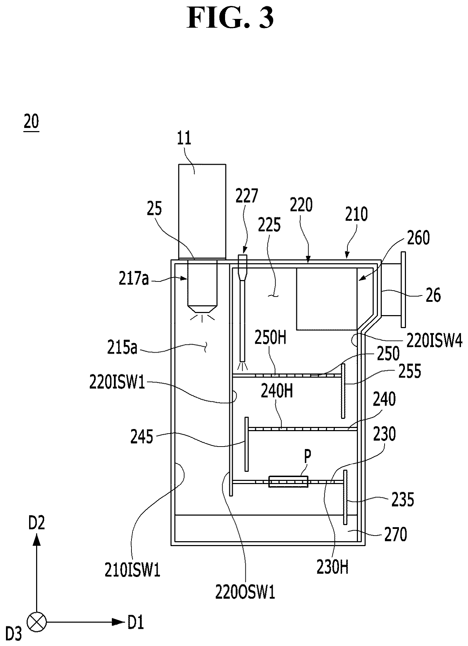

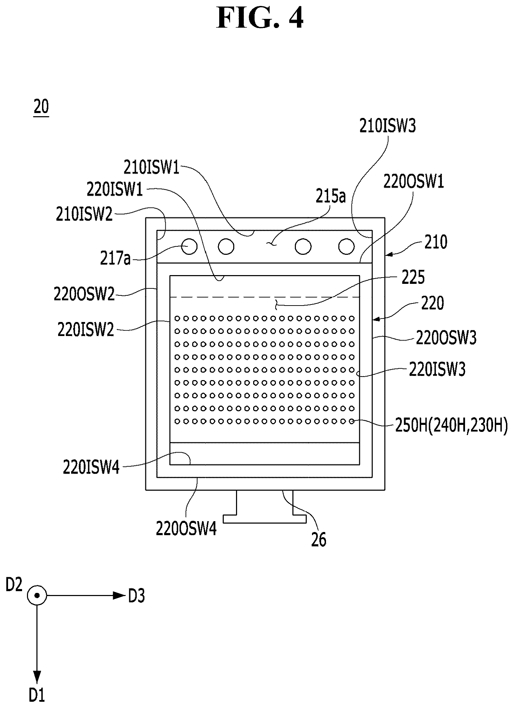

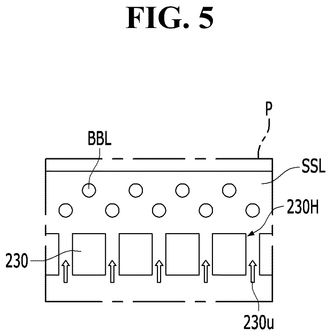

FIG. 2 is an exemplary perspective view for explaining the scrubber for semiconductor apparatus of FIG. 1. FIG. 3 is an exemplary cross-sectional view for explaining the scrubber for semiconductor apparatus of FIG. 1. FIG. 4 is an exemplary plan view for explaining the scrubber for semiconductor apparatus of FIG. 1. FIG. 5 is an enlarged view of the P area of FIG. 3.

Referring FIGS. 2 and 5, the scrubber 20 for semiconductor apparatus according to some embodiments of the present invention may include an absorption tower 210, a housing 220, a first tray 230, a second tray 240, a third tray 250, a solution supply nozzle 227, and a demister 260.

First, the absorption tower 210 may be provided. The absorption tower 210 may be an external housing of the scrubber 20 for semiconductor apparatus. The gas mixture (Gm of FIG. 1) may be provided into the absorption tower 210, and the gas mixture (Gm of FIG. 1) may be separated into the first gas (G1 of FIG. 1) and the second gas (G2 of FIG. 1) inside the absorption tower 210. The interior of the absorption tower 210 may include a first scrubbing space 225 and a second scrubbing space 215a. A first scrubbing process may be performed in the first scrubbing space 225, and a second scrubbing process may be performed in the second scrubbing space 215a.

In some embodiments, the absorption tower 210 may include a first inner side wall 210ISW1, a second inner side wall 210ISW2, a third inner side wall 210ISW3, and a fourth inner side wall (not shown).

The first inner side wall 210ISW1 of the absorption tower 210 may face the fourth inner side wall of the absorption tower 210 in a first direction D1, and the second inner side wall 210ISW2 of the absorption tower 210 may face the third inner side wall 210ISW3 of the absorption tower 210 in a third direction D3. The first inner side wall 210ISW1 of the absorption tower 210 may be connected to the second inner side wall 210ISW2 of the absorption tower 210 and the third inner side wall 210ISW3 of the absorption tower 210. The first and second scrubbing processes may be performed in a space defined by the first inner side wall 210ISW1 of the absorption tower 210, the second inner side wall 210ISW2 of the absorption tower 210, the third inner side wall 210ISW3 of the absorption tower 210, and the fourth inner side wall of the absorption tower 210.

The housing 220 may be disposed in the absorption tower 210. The housing 220 may define a first scrubbing space 225. The first scrubbing process may be performed within the first scrubbing space 225. A detailed description of the first scrubbing process will be provided later.

In some embodiments, the housing 220 may include a first inner side wall 220ISW1, a second inner side wall 220ISW2, a third inner side wall 220ISW3, and a fourth inner side wall 220ISW4. The first inner side wall 220ISW1 of the housing 220, the second inner side wall 220ISW2 of the housing 220, the third inner side wall 220ISW3 of the housing 220, and the fourth inner side wall 220ISW1 of the housing 220 may define the first scrubbing space 225.

In some embodiments, the inner side walls of the housing 220 may extend in a second direction D2. The second direction D2 may be a direction perpendicular to the ground. The first inner side wall 220ISW1 of the housing 220 may be spaced apart from the fourth inner side wall 220ISW4 of the housing 220 in the first direction D1. The second inner side wall 220ISW2 of the housing 220 may be spaced apart from the third inner side wall 220ISW3 of the housing 220 in the third direction D3. The first inner side wall 220ISW1 of the housing 220 may face the fourth inner side wall 220ISW4 of the housing 220. The second inner side wall 220ISW2 of the housing 220 may face the third inner side wall 220ISW3 of the housing 220.

In this specification, the first direction D1 and the third direction D3 may intersect with each other. The first direction D1 and the second direction D2 may intersect with each other. The second direction D2 and the third direction D3 may intersect with each other. That is, in this specification, the first direction D1, the second direction D2, and the third direction D3 may be substantially perpendicular to each other.

A first tray 230, a second tray 240, and a third tray 250 are disposed in the housing 220. That is, the first tray 230, the second tray 240, and the third tray 250 are disposed in the first scrubbing space 225.

In FIGS. 2 to 5, the scrubber 20 for semiconductor apparatus of the present invention is illustrated as including three trays, but the technical idea of the present invention is not limited thereto. The scrubber 20 for semiconductor apparatus according to some embodiments of the present invention may include at least one tray. That is, the trays may be arranged one or two inside the housing 220, or of course, four or more trays may be arranged.

The first tray 230 may be arranged at the lowest position among the trays arranged inside the housing 220. One end of the first tray 230 may be connected to and fixed to the inner side wall of the housing 220. Specifically, one end of the first tray 230 may be connected to and fixed to the first inner side wall 220ISW1 of the housing 220. The first tray 230 may be connected to the first inner side wall 220ISW1 of the housing 220 and may extend in the first direction D1 intersecting the first inner side wall 220ISW1. More specifically, the first tray 230 may be disposed on a plane which the first direction D1 and the third direction D3 extend.

Similarly, the first tray 230 may be connected to and fixed to the second inner side wall 220ISW2 of the housing 220 and the third inner side wall 220ISW of the housing 220.

However, the other end of the first tray 230 may not be connected and fixed to the fourth inner side wall 220ISW4 of the housing 220. The other end of the first tray 230 may be spaced apart from the fourth inner side wall 220ISW4 of the housing 220 in the first direction D1. The space from the other end of the first tray 230 to the fourth inner side wall 220ISW4 of the housing 220 may be a space in which a first scrubbing solution SSL, which will be described later, flows downward (for example, in the second direction D2).

The scrubber 20 for semiconductor apparatus according to some embodiments may further include a first tray hole 230H, and a first tray wall 235.

The first tray hole 230H may be formed inside the first tray 230. The first tray hole 230H may extend from a lower surface of the first tray 230 to an upper surface of the first tray 230. That is, the first tray hole 230H may penetrate the first tray 230 in the second direction D2. The gas mixture (Gm of FIG. 1) may ascend in the second direction D2 by passing through the first tray hole 230H (see reference numeral 230u)

The upper surface of the first tray 230 may face the demister 260 to be described later, and the lower surface of the first tray 230 may face a scrubbing solution storage 270 to be described later.

The first tray wall 235 may be attached to the other end of the first tray 230. The first tray wall 235 may be interposed between the first tray 230 and the fourth inner side wall 220ISW4 of the housing 220. The first tray wall 235 may extend in the second direction D2. In some embodiments, a portion of the first tray wall 235 may protrude from the upper surface of the first tray 230 in the second direction. Another portion of the first tray wall 235 may protrude from the lower surface of the first tray 230 in the second direction D2.

In some embodiments, at least a portion of the first tray wall 235 protruding from the lower surface of the first tray 230 in the second direction D2 may be disposed within the scrubbing solution storage 270, but the technical idea of the present invention is not limited thereto.

The second tray 240 may be disposed on the first tray 230. Specifically, the second tray 240 may be disposed on the upper surface of the first tray 230. One end of the second tray 240 may be connected to and fixed to the inner side wall of the housing 220. Specifically, one end of the second tray 240 may be connected to and fixed to the fourth inner side wall 220ISW4 of the housing 220. The second tray 240 may be connected to the fourth inner side wall 220ISW4 of the housing 220 and may extend in the first direction D1 intersecting the fourth inner side wall 220ISW4. More specifically, the second tray 240 may be disposed on a plane on which the first direction D1 and the third direction D3.

Similarly, the second tray 240 may be connected to and fixed to the second inner side wall 220ISW2 of the housing 220 and the third inner side wall 220ISW of the housing 220.

However, the other end of the second tray 240 may not be connected and fixed to the first inner side wall 220ISW1 of the housing 220. The other end of the second tray 240 may be spaced apart from the first inner side wall 220ISW1 of the housing 220 in the first direction D1. The space from the other end of the second tray 240 to the first inner side wall 220ISW1 of the housing 220 may be a space in which the first scrubbing solution SSL, which will be described later, flows downward (for example, in the second direction D2).

The scrubber 20 for semiconductor apparatus according to some embodiments may further include a second tray hole 240H and a second tray wall 245.

The second tray hole 240H may be formed inside the second tray 240. The second tray hole 240H may extend from a lower surface of the second tray 240 to an upper surface of the second tray 240. The second tray hole 240H may penetrate the second tray 240 in a second direction D2. The gas mixture (Gm of FIG. 1) may rise in the second direction D2 by passing through the second tray hole 240H.

The upper surface of the second tray 240 may face the demister 260 to be described later, and the lower surface of the second tray 240 may face the upper surface of the first tray 230.

The second tray wall 245 may be attached to the other end of the second tray 240. The second tray wall 245 may be interposed between the second tray 240 and the first inner side wall 220ISW1 of the housing 220. The second tray wall 245 may extend in the second direction D2. In some embodiments, a portion of the second tray wall 245 may protrude from the upper surface of the second tray 240 in the second direction D2. Another portion of the second tray wall 245 may protrude from the lower surface of the second tray 240 in the second direction D2.

In some embodiments, the first tray 230 and the second tray 240 do not completely overlap in the second direction D2. The first scrubbing solution SSL that flows downward over the second tray wall 245 may be discharged onto the upper surface of the first tray 230. In other words, a center of the first tray 230 and a center of the second tray 240 may be offset from each other.

The third tray 250 may be disposed on the second tray 240. Specifically, the third tray 250 may be disposed on the upper surface of the second tray 240. One end of the third tray 250 may be connected to and fixed to the inner side wall of the housing 220. Specifically, one end of the third tray 250 may be connected to and fixed to the first inner side wall 220ISW1 of the housing 220. The third tray 250 may be connected to the first inner side wall 220ISW1 of the housing 220 and may extend in a first direction D1 intersecting the first inner side wall 220ISW1. More specifically, the third tray 250 may be disposed on a plane on which the first direction D1 and the third direction D3 extend. Similarly, the third tray 250 may be connected to and fixed to the second inner side wall 220ISW2 of the housing 220 and the third inner side wall 220ISW of the housing 220.

However, the other end of the third tray 250 may not be fixedly connected to the fourth inner side wall 220ISW4 of the housing 220. The other end of the third tray 250 may be spaced apart from the fourth inner side wall 220ISW4 of the housing 220 in the first direction D1. The space from the other end of the third tray 250 to the fourth inner side wall 220ISW4 of the housing 220 may be a space in which the first scrubbing solution SSL, which will be described later, flows downward (for example, in the second direction D2).

The scrubber 20 for semiconductor apparatus according to some embodiments may further include a third tray hole 250H and a third tray wall 255.

The third tray hole 250H may be formed inside the third tray 250. The third tray hole 250H may extend from a lower surface of the third tray 250 to an upper surface of the third tray 250. The third tray hole 250H may penetrate the third tray 250 in the second direction (D2). The gas mixture (Gm of FIG. 1) may rise in the second direction D2 by passing through the third tray hole 250H.

The upper surface of the third tray 250 may face the demister 260 to be described later, and the lower surface of the third tray 250 may face the upper surface of the second tray 240.

The third tray wall 255 may be attached to the other end of the third tray 250. The third tray wall 255 may be interposed between the third tray 250 and the fourth inner side wall 220ISW4 of the housing 220. The third tray wall 255 may extend in the second direction D2. In some embodiments, a portion of the third tray wall 255 may protrude from the upper surface of the third tray 250 in the second direction D2. Another portion of the third tray wall 255 may protrude from the lower surface of the third tray 250 in the second direction D2.

In some embodiments, the third tray 250 and the second tray 240 do not completely overlap in the second direction D2. The first scrubbing solution SSL that flows downward over the third tray wall 255 may be discharged onto the upper surface of the second tray 240. In other words, a center of the third tray 250 and the center of the second tray 240 may be offset from each other.

However, the third tray 250 and the first tray 230 may completely overlap in the second direction D2. That is, the center of the third tray 250 and the center of the first tray 230 may overlap in the second direction D2.

In some embodiments, the first to third tray holes 230H, 240H, 250H may completely overlap in the second direction D2. However, the technical idea of the present invention is not limited thereto. The first to third tray holes 230H, 240H, 250H may not completely overlap in the second direction D2, and may only partially overlap.

The solution supply nozzle 227 may be disposed in the housing 220. The solution supply nozzle 227 may be connected to an upper part of the absorption tower 210 and the housing 220 and may extend in the second direction D2. The solution supply nozzle 227 may be connected to a pipe (not shown) installed exterior the absorption tower 210. The solution supply nozzle 227 may supply the first scrubbing solution SSL into the housing 220. The first scrubbing solution SSL may be supplied from the solution supply nozzle 227 and discharged onto the upper surface of the third tray 250.

The first scrubbing solution SSL may be, for example, water. However, the technical idea of the present invention is not limited thereto.

The first scrubbing solution SSL may be discharged onto the upper surface of the third tray 250, and may flow from the upper surface of the third tray 250 toward the third tray wall 255 while the first scrubbing process is performed. At this time, the first scrubbing solution SSL does not flow downward through the third tray hole 250H. The first scrubbing solution SSL may flow over the third tray wall 255 to a lower part of the absorption tower 210.

The first scrubbing solution SSL that has passed the third tray wall 255 is discharged again to the upper surface of the second tray 240. The first scrubbing solution SSL may flow from the upper surface of the second tray 240 toward the second tray wall 245 while the first scrubbing process is performed. At this time, the first scrubbing solution SSL does not flow downward through the second tray hole 240H. The first scrubbing solution SSL may flow over the second tray wall 245 to the lower part of the absorption tower 210.

Similarly, the first scrubbing solution SSL that exceeds the second tray wall 245 is discharged back to the upper surface of the first tray 230. The first scrubbing solution SSL may flow from the upper surface of the first tray 230 toward the first tray wall 235 while the first scrubbing process is performed. At this time, the first scrubbing solution SSL does not flow downward through the first tray hole 230H. The first scrubbing solution SSL may flow over the first tray wall 235 to the lower part of the absorption tower 210.

Finally, the first scrubbing solution SSL that has passed the first tray wall 235 may be stored in the scrubbing solution storage 270 provided at the lower part of the absorption tower 210. A contaminated scrubbing solution may be stored in the scrubbing solution storage 270. For example, the contaminated scrubbing solution may be a solution in which the first gas (G1 of FIG. 1) is dissolved in the water. More specifically, the contaminated scrubbing solution may be a solution in which the first gas (G1 of FIG. 1) is dissolved in the water.

In some embodiments, the first gas may be a hydrophilic gas. For example, the first gas may be isopropyl alcohol (IPA) and/or ammonia, although the technical idea of the present invention is not limited thereto.

The demister 260 may be disposed on the upper part of the absorption tower 210. The demister 260 may be disposed on an upper part of the housing 220. The demister 260 may be used to remove moisture from the gas after the first scrubbing process is performed. That is, the water may be removed from the gas in which the water and the second gas (G2 of FIG. 1) are mixed after the first scrubbing process is performed using the demister 260.

The demister 260 may be connected to the gas outlet port 26. The gas filtered through the demister 260 may be discharged to the exterior of the absorption tower 210 through the gas outlet port 26.

When using the scrubber 20 for semiconductor apparatus according to some embodiments, the gas harmful to the human body may be dissolved in the scrubbing solution. Accordingly, the gas harmful to the human body may be removed from by-products generated after the semiconductor process is performed and discharged to the exterior of the absorption tower 210.

The scrubber 20 for semiconductor apparatus according to some embodiments may include the second scrubbing space 215a.

The second scrubbing space 215a may be defined by the inner side wall of the absorption tower 210, and outer side wall of the housing 220. For example, the second scrubbing space 215a may be defined by the first inner side wall 210ISW1 of the absorption tower 210, the second inner side wall 210ISW2 of the absorption tower 210, the third inner side wall 210ISW3 of the absorption tower 210, and a first outer side wall 2200SW1 of the housing 220.

The first inner side wall 210ISW1 of the absorption tower 210 may face the first outer side wall 220OSW1 of the housing. The first outer side wall 220OSW1 of the housing may be opposed to the first inner side wall 220ISW1 of the housing 220.

In some embodiments, the housing 220 may further include a second outer side wall 2200SW2, a third outer side wall 220OSW3, and a fourth outer side wall 220OSW4. The second outer side wall 220OSW2 of the housing 220 may be opposed to the second inner side wall 220ISW2 of the housing 220, the third outer side wall 220OSW3 of the housing 220 may be opposed to the third inner side wall 220ISW3 of the housing 220, and the fourth outer side wall 220OSW2 of the housing 220 may be opposed to the fourth inner side wall 220ISW4 of the housing.

The second scrubbing process is performed in the second scrubbing space 215a. The second scrubbing process may mean a process of dissolving the first gas G1 among the gas mixture(Gm of FIG. 1) injected into the absorption tower 210 in the second scrubbing solution.

In some embodiments, the second scrubbing solution may be provided into the interior of the absorption tower 210 through a first shower head 217a. The second scrubbing solution may be provided into the second scrubbing space 215a through the first shower head 217a.

The second scrubbing solution is provided from the upper part to the lower part of the second scrubbing space 215a, and while the gas mixture (Gm of FIG. 1) flows from the upper part to the lower part of the second scrubbing space 215a, at least a portion of the first gas (G1 of FIG. 1) may be dissolved in the second scrubbing solution. In some embodiments, the second scrubbing solution may include water. However, the technical idea of the present invention is not limited thereto.

In some embodiments, the first shower head 217a may be a spray nozzle. The first shower head 217a may supply the second scrubbing solution having small particles to the second scrubbing space 215a. Accordingly, the contact area of the second scrubbing solution and the gas mixture may be increased. Accordingly, the scrubber 20 for semiconductor apparatus having improved scrubbing efficiency may be provided.

The first shower head 217a may be installed in the upper part of the absorption tower 210. The first shower head 217a may be connected to a pipe (not shown) installed on the exterior of the absorption tower 210.

In some embodiments, the first shower head 217a and the solution supply nozzle 227 may be connected to the scrubbing solution storage 270 via the pipe (not shown) that is connected to the scrubbing solution storage 270, respectively. That is, the second scrubbing solution provided to the second scrubbing space 215a via the first shower head 217a may be the contaminated scrubbing solution stored in the scrubbing solution storage 270. Similarly, the first scrubbing solution provided to the first scrubbing space 225 via the solution supply nozzle 227 may be the contaminated scrubbing solution stored in the scrubbing solution storage 270.

In this way, when using the scrubber 20 for semiconductor apparatus of the present invention, the scrubbing solution can be recycled, and thus, the amount of water used in the scrubbing process can be reduced.

In some embodiments, the gas inlet port 25 may be installed on one side of the second scrubbing space 215a. The gas mixture (Gm of FIG.1) to be injected into the interior of the absorption tower 210 may be injected into the interior of the absorption tower 210 through the gas inlet port 25. The gas inlet port 25 may be connected to the first pipe 11, and since the other side of the first pipe 11 is connected to the semiconductor chamber (10 of FIG. 1), the gas mixture (Gm of FIG. 1) injected into the gas inlet port 25 may be provided from the semiconductor chamber.

In some embodiments, specifically, a negative pressure may be provided to the first scrubbing space 225 through the gas outlet port 26. That is, the pressure at the gas inlet port 25 and the pressure at the gas outlet port 26 may be different from each other. Accordingly, the gas mixture Gm may flow from the gas inlet port 25 toward the gas outlet port 26. The first scrubbing process and the second scrubbing process may be performed by utilizing the difference between the pressure at the gas inlet port 25 and the pressure at the gas outlet port 26.

In some embodiments, the first scrubbing space 225 and the second scrubbing space 215a may be connected to each other at the lower part of the absorption tower 210. That is, the gas mixture injected into the second scrubbing space 215a may flow from the upper part of the second scrubbing space 215a to the lower part of the second scrubbing space 215a and may be injected into the first scrubbing space 225 from the lower part of the absorption tower 210. In the first scrubbing space 225, the gas mixture (Gm of FIG. 1) may ascend in the second direction D2.

When using the scrubber 20 for semiconductor apparatus according to some embodiments, the contact area of the gas in contact with the scrubbing solution may be increased. Specifically, the contact area may be increased by forming bubbles within the scrubbing solution.

For example, in FIG. 5, the gas mixture (Gm of FIG. 1) may pass through the first tray hole 230H and rise in the second direction D2 (see reference numeral 230u).

After the gas mixture (Gm of FIG. 1) passes through the first tray hole 230H, the bubbles BBL may be formed on the upper surface of the first tray 230. The bubbles BBL may be formed in the first scrubbing solution SSL. At a portion where the bubbles BBL and the first scrubbing solution SSL come into contact, the first gas (G1 of FIG. 1) may be dissolved in the first scrubbing solution SSL.

Although not illustrated, the gas mixture (Gm of FIG. 1) may rise in the second direction D2 after passing through the first tray hole 230H and then through the second tray hole 240H. After the gas mixture (Gm of FIG. 1) passes through the second tray hole 240H, the bubbles may be formed on the upper surface of the second tray 240. Similarly, the gas mixture (Gm of FIG. 1) may rise in the second direction D2 after passing through the second tray hole 240H and then through the third tray hole 250H. After the gas mixture (Gm of FIG. 1) passes through the third tray hole 250H, the bubbles may be formed on the upper surface of the third tray 250.

When the bubbles (BBL) are formed in the scrubbing solution, the contact area between the gas and the scrubbing solution may be increased. Accordingly, the scrubber 20 for semiconductor apparatus with improved scrubbing efficiency may be provided.

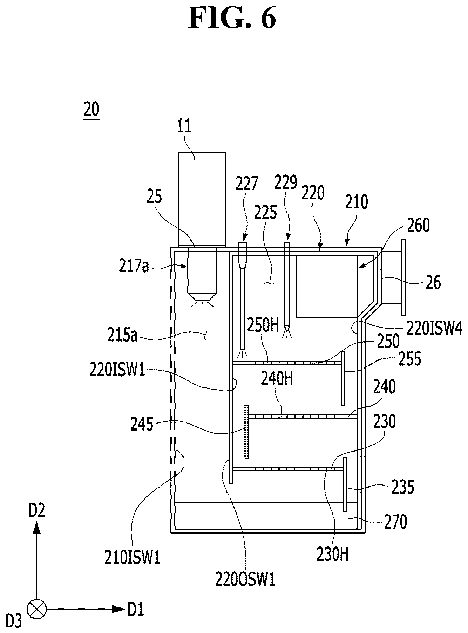

Hereinafter, the scrubber for semiconductor apparatus according to some other embodiments of the present invention will be described with reference to FIGS. 6 to 11. For convenience of explanation, any content that overlaps with the content described using FIGS. 1 to 5 will be briefly described or omitted.

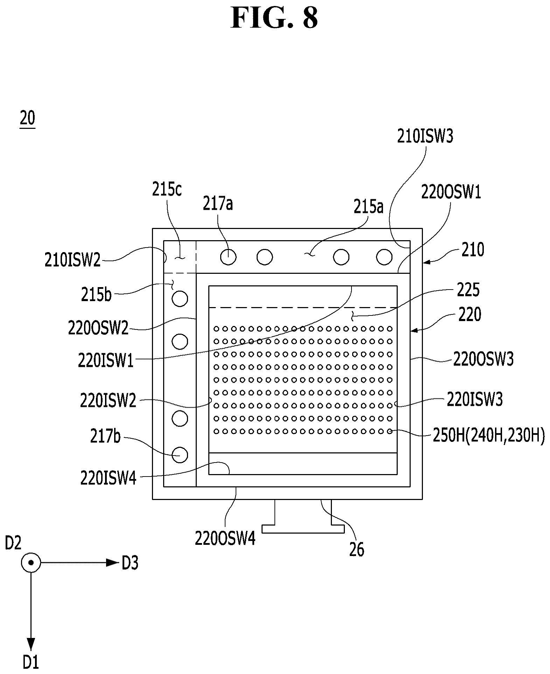

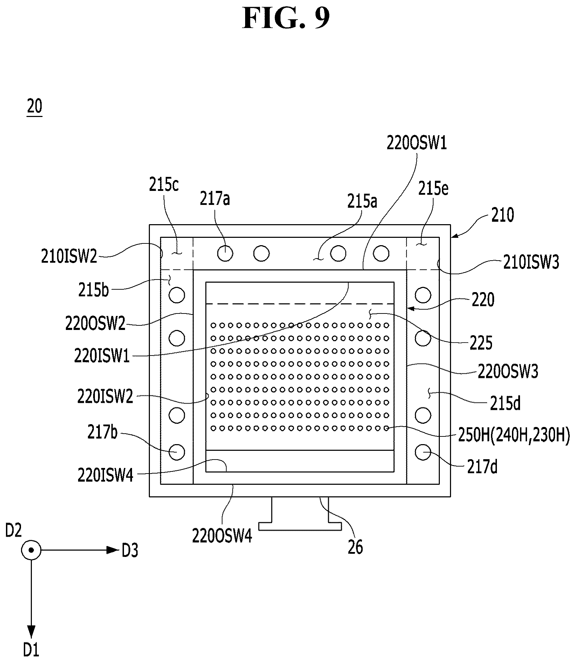

FIGS. 6 to 11 are drawings for explaining the scrubber for semiconductor apparatus according to some other embodiments of the present invention. For reference, FIGS. 6, 7, 10, and 11 may be cross-sectional views of the scrubber for semiconductor apparatus according to some other embodiments of the present invention, respectively, and FIGS. 8 and 9 may be plan views of the scrubber for semiconductor apparatus according to some other embodiments of the present invention, respectively.

First, referring to FIG. 6, the scrubber 20 for semiconductor apparatus according to some embodiments may further include a sub solution supply nozzle 229.

The sub solution supply nozzle 229 is disposed on the upper part of the absorption tower 210, specifically, the sub solution supply nozzle 229 may be disposed on the upper part of the housing 220. The sub solution supply nozzle 229 may supply the scrubbing solution to the upper surface of the third tray 250. The scrubbing solution may be water, but the technical idea of the present invention is not limited thereto.

The sub solution supply nozzle 229 may be a spray nozzle. The sub solution supply nozzle 229 may supply the scrubbing solution having small particles onto the upper surface of the third tray 250. Accordingly, the contact area where the scrubbing solution and the gas mixture come into contact may be increased. Accordingly, the scrubber 20 for semiconductor apparatus with improved scrubbing efficiency may be provided.

The sub solution supply nozzle 229 may continuously supply the scrubbing solution while the first scrubbing process is performed or may supply the scrubbing solution only for a portion of the time while the first scrubbing process is performed.

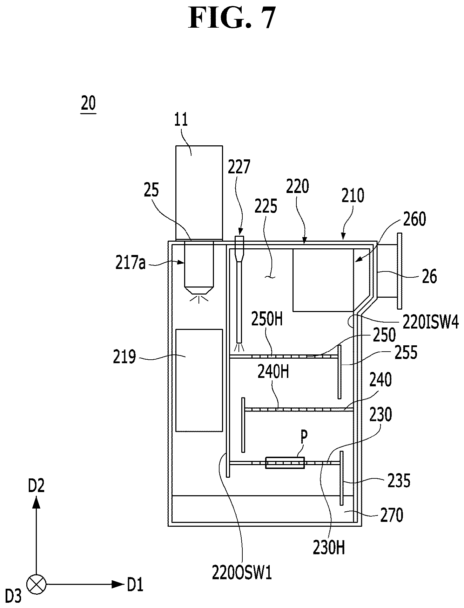

Referring to FIG. 7, the scrubber 20 for semiconductor apparatus according to some embodiments may further include a packing area 219.

The packing area 219 may be disposed in the second scrubbing space 215a. The packing area 219 may be interposed between the first shower head 217a and the scrubbing solution storage 270.

Packing elements may be arranged in the packing area 219. At least one packing element may be disposed. The first gas may actively contact the packing elements in the second scrubbing space 215a. The packing elements may help the first gas G1 dissolve into the second scrubbing solution. Accordingly, the scrubbing efficiency of the scrubber 20 for semiconductor apparatus may be improved.

Referring to FIG. 8, the scrubber 20 for semiconductor apparatus according to some embodiments may further include a third scrubbing space 215b and a first connecting space 215c.

The third scrubbing space 215b may be defined by the inner side wall of the absorption tower 210 and the outer side wall of the housing. For example, the third scrubbing space 215b may be defined by the second inner side wall 210ISW2 of the absorption tower 210, the second outer side wall 2200SW2 of the housing 220, and the fourth inner side wall of the absorption tower 210.

The second inner side wall 210ISW2 of the absorption tower 210 may face the second outer side wall 220OSW2 of the housing 220. The second outer side wall 220OSW2 of the housing may be opposed to the second inner side wall 220ISW2 of the housing 220.

In the third scrubbing space 215b, a third scrubbing process may be performed. The third scrubbing process may mean a process of dissolving the first gas G1 among the gas mixture (Gm of FIG. 1) injected into the absorption tower 210 into a third scrubbing solution to be described later.

In some embodiments, the third scrubbing solution is provided into the interior of the absorption tower 210 through a second shower head 217b. The third scrubbing solution may be provided into the third scrubbing space 215b through the second shower head 217b.

The third scrubbing solution is provided from the upper part to the lower part of the third scrubbing space 215b, and while the gas mixture (Gm of FIG. 1) flows from the upper part to the lower part of the third scrubbing space 215b, at least a portion of the first gas (G1 of FIG. 1) may be dissolved in the third scrubbing solution. In some embodiments, the third scrubbing solution may include water, but the technical idea of the present invention is not limited thereto.

The second shower head 217b may be installed in the upper part of the absorption tower 210. The second shower head 217b may be connected to the pipe (not shown) installed exterior the absorption tower 210.

In some embodiments, the second shower head 217b may be a spray nozzle. The second shower head 217b may supply the third scrubbing solution having small particles to the third scrubbing space 215b. Therefore, the contact area where the third scrubbing solution and the gas mixture come into contact may be increased. Accordingly, the scrubber 20 for semiconductor apparatus with improved scrubbing efficiency may be provided.

The first connecting space 215c may be interposed between the third scrubbing space 215b and the second scrubbing space 215a.

The gas mixture (Gm of FIG. 1) injected into the interior of the absorption tower 210 through the gas inlet port 25 arranged on one side of the second scrubbing space 215a may move to the third scrubbing space 215b through the first connecting space 215c.

In some embodiments, the first scrubbing space 225 and the third scrubbing space 215b may be connected to each other at the lower part of the absorption tower 210. That is, the gas mixture injected into the third scrubbing space 215b may flow from the upper part to the lower part of the third scrubbing space 215b and may be injected into the first scrubbing space 225 from the lower part of the absorption tower 210. In the first scrubbing space 225, the gas mixture may rise in the second direction D2.

According to some embodiments, a third scrubbing process may be additionally performed in the third scrubbing space 215b. Accordingly, the scrubber 20 for semiconductor apparatus with improved scrubbing efficiency may be provided.

Referring to FIG. 9, the scrubber 20 for semiconductor apparatus according to some embodiments further include the third scrubbing space 215b, the first connecting space 215c, a fourth scrubbing space 215d, and a second connecting space 215e.

The third scrubbing space 215b and the first connecting space 215c may be the same as the third scrubbing space 215b and the first connecting space 215c described in FIG. 8, so a detailed description thereof is omitted.

The fourth scrubbing space 215d may be defined by the inner side wall of the absorption tower 210 and the outer side wall of the housing. For example, the fourth scrubbing space 215d may be defined by the third inner side wall 210ISW3 of the absorption tower 210, the third outer side wall 2200SW3 of the housing, and the fourth inner side wall of the absorption 210.

The fourth scrubbing space 215d may be disposed spaced apart from the third scrubbing space 215b in the third direction D3. The housing 220 may be interposed between the fourth scrubbing space 215d and the third scrubbing space 215b. The first scrubbing space 225 may be interposed between the fourth scrubbing space 215d and the third scrubbing space 215b.

The third inner side wall 210ISW3 of the absorption tower 210 may face the third outer side wall 220OSW3 of the housing 220. The third outer side wall 2200SW3 of the housing 220 may be opposed to the third inner side wall 220ISW3 of the housing 220.

In the fourth scrubbing space 215d, a fourth scrubbing process may be performed. The fourth scrubbing process may mean a process of dissolving the first gas G1 among the gas mixture (Gm of FIG. 1) injected into the absorption tower 210 into a fourth scrubbing solution to be described later.

In some embodiments, the fourth scrubbing solution may be provided into the interior of the absorption tower 210 through the third shower head 217d. The fourth scrubbing solution may be provided into the fourth scrubbing space 215d through the third shower head 217d. In some embodiments, the fourth scrubbing solution may include water, but the technical idea of the present invention is not limited thereto.

The fourth scrubbing solution is provided from the upper part to the lower part of the fourth scrubbing space 215d, and while the gas mixture (Gm of FIG. 1) flows from the upper part to the lower part of the fourth scrubbing space 215d, at least a portion of the first gas (G1 of FIG. 1) may be dissolved in the fourth scrubbing solution.

The third shower head 217d may be installed in the upper part of the absorption tower 210. The third shower head 217d may be connected to the pipe (not shown) installed on the exterior of the absorption tower 210.

In some embodiments, the third shower head 217d may be a spray nozzle. The third shower head 217d may supply the fourth scrubbing solution having small particles to the fourth scrubbing space 215d. Accordingly, the contact area of the fourth scrubbing solution and the gas mixture may be increased. Accordingly, the scrubber 20 for semiconductor apparatus with improved scrubbing efficiency may be provided.

The second connecting space 215e may be interposed between the second scrubbing space 215b and the fourth scrubbing space 215d.

Accordingly, the gas mixture (Gm of FIG. 1) injected into the interior of the absorption tower 210 through the gas inlet port 25 disposed on one side of the second scrubbing space 215a may move to the fourth scrubbing space 215d through the second connecting space 215e.

In some embodiments, the first scrubbing space 225 and the fourth scrubbing space 215d may be connected to each other at the lower part of the absorption tower 210. That is, the gas mixture injected into the fourth scrubbing space 215d may flow from the upper part of the fourth scrubbing space 215d to the lower part of the fourth scrubbing space 215d and may be injected into the first scrubbing space 225 from the lower part of the absorption tower 210. In the first scrubbing space 225, the gas mixture may rise in the second direction D2.

According to some embodiments, a fourth scrubbing process may be additionally performed in a fourth scrubbing space 215d. Accordingly, the scrubber 20 for semiconductor apparatus with improved scrubbing efficiency may be provided.

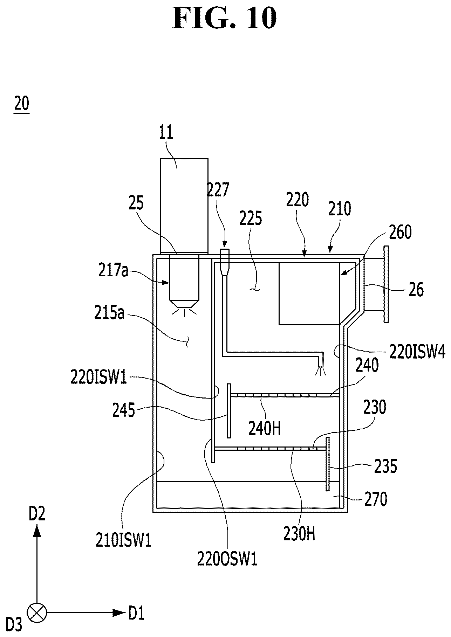

Referring to FIG. 10, the scrubber 20 for semiconductor apparatus according to some embodiments may include two trays 230, 240. That is, the scrubber 20 for semiconductor apparatus may include the first tray 230 and the second tray 240.

The second tray 240 may be disposed on the first tray 230. The second tray 240 may be disposed on the upper surface of the first tray 230. The first tray 230 may be disposed on the lower surface of the second tray 240. No other tray may be disposed on the upper surface of the second tray 240.

In some embodiments, the first scrubbing solution (SSL of FIG. 5) may be supplied from the solution supply nozzle 227 and discharged to the upper surface of the second tray 240. Specifically, the first scrubbing solution (SSL of FIG. 5) may be discharged to an area of the upper surface of the second tray 240 adjacent to the fourth inner side wall 220ISW4 of the housing 220. The first scrubbing solution (SSL of FIG. 5) may be discharged to an area of the upper surface of the second tray 240 that is furthest from the second tray wall 245.

The discharged first scrubbing solution (SSL of FIG. 5) may flow from the upper surface of the second tray 240 toward the second tray wall 245 while the first scrubbing process is performed. The first scrubbing solution (SSL of FIG. 5) may flow downward over the second tray wall 245. At this time, the first scrubbing solution (SSL of FIG. 5) does not flow downward through the second tray hole 240H. The first scrubbing solution (SSL of FIG. 5) that has flowed downward over the second tray wall 245 may be discharged onto the upper surface of the first tray 230.

Similarly, the first scrubbing solution (SSL of FIG. 5) may flow from the upper surface of the first tray 230 toward the first tray wall 235 while the first scrubbing process is performed. At this time, the first scrubbing solution (SSL of FIG. 5) does not flow downward through the first tray hole 230H. The first scrubbing solution (SSL of FIG. 5) may flow over the first tray wall 235 to the lower part of the absorption tower 210.

The scrubber 20 for semiconductor apparatus illustrated in FIG. 10 includes only two trays 230, 240. Therefore, the height of the scrubber 20 for semiconductor apparatus in the second direction D2 may be reduced. That is, when scrubber 20 for semiconductor apparatus according to some embodiments of the present invention is used, space efficiency may be improved.

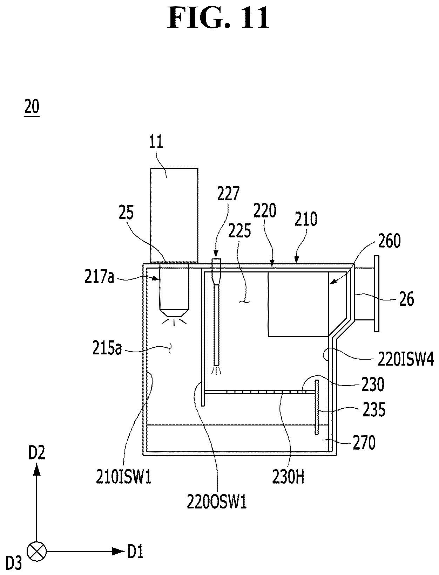

Referring to FIG. 11, the scrubber 20 for semiconductor apparatus according to some embodiments may include one tray 230. That is, the scrubber 20 for semiconductor apparatus may include the first tray 230.

In some embodiments, the first scrubbing solution (SSL of FIG. 5) may be supplied from the solution supply nozzle 227 and discharged to the upper surface of the first tray 230. Specifically, the first scrubbing solution (SSL of FIG. 5) may be discharged to an area of the upper surface of the first tray 230 adjacent to the first inner side wall 220ISW1 of the housing 220. The first scrubbing solution (SSL of FIG. 5) may be discharged to an area of the upper surface of the first tray 230 that is furthest from the first tray wall 235.

The first scrubbing solution (SSL of FIG. 5) may flow from the upper surface of the first tray 230 toward the first tray wall 235 while the first scrubbing process is performed. At this time, the first scrubbing solution (SSL of FIG. 5) does not flow downward through the first tray hole 230H. The first scrubbing solution (SSL of FIG. 5) may flow over the first tray wall 235 to the lower part of the absorption tower 210.

The scrubber 20 for semiconductor apparatus illustrated in FIG. 11 includes only one tray 230. Therefore, the height of the scrubber 20 for semiconductor apparatus in the second direction D2 may be reduced. That is, when the scrubber 20 for semiconductor apparatus according to some other embodiments of the present invention is used, space efficiency may be further improved.

Although not shown, the scrubber 20 for semiconductor apparatus according to some embodiments may not include the first shower head 217a. That is, the second scrubbing process may not be performed in the second scrubbing space 215a. In this case, the gas mixture injected into the interior of the absorption tower 210 may pass through the second scrubbing space 215a and be injected into the first scrubbing space 225, and the first scrubbing process may be performed in the first scrubbing space 225.

As another example, the scrubber 20 for semiconductor apparatus according to some embodiments may not include the second scrubbing space 215a. In this case, the gas inlet port 25 may be arranged at the lower part of the absorption tower 210. In this case, the gas mixture (Gm of FIG. 1) may be provided from the lower part of the absorption tower 210 and may rise in the second direction D2 toward the upper part of the absorption tower 210.

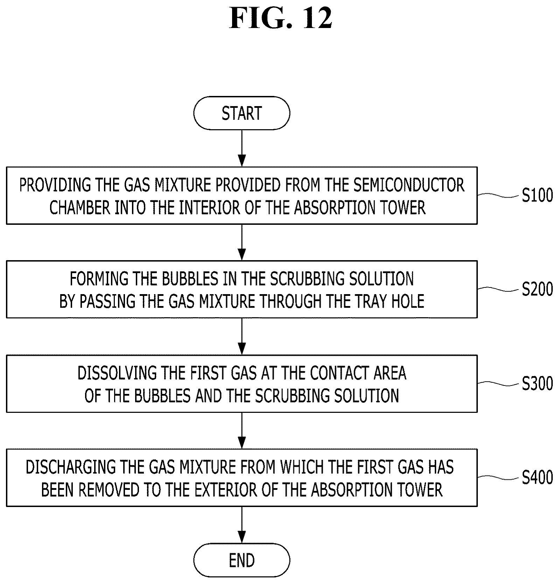

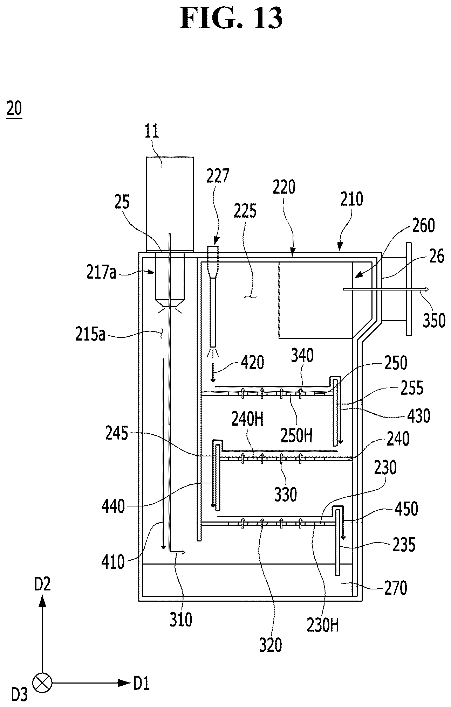

Hereinafter, with reference to FIGS. 12 and 13, an operating method of the scrubber for semiconductor apparatus according to some embodiments of the present invention will be described. For reference, FIG. 12 may be an exemplary flowchart for explaining the operating method of the scrubber for semiconductor apparatus according to some embodiments of the present invention.

FIGS. 12 and 13 are drawings for explaining an operating method of the scrubber for semiconductor apparatus according to some embodiments of the present invention.

First, referring to FIG. 12, the operating method of the scrubber for semiconductor apparatus according to some embodiments of the present invention may include providing the gas mixture provided from the semiconductor chamber into the interior of the absorption tower S100, forming the bubbles in the scrubbing solution by passing the gas mixture through the tray hole S200, dissolving the first gas at the contact area of the bubbles and the scrubbing solution S300, and discharging the gas mixture from which the first gas has been removed to the exterior of the absorption tower S400. The concentration of a substance harmful included in the gas discharged to the exterior of the absorption tower may be very low.

Specifically, referring to FIG. 1 and FIG. 13, the gas mixture Gm may be provided from the semiconductor chamber 10 to the scrubber 20 for semiconductor apparatus. The gas mixture Gm may pass through the first pipe 11 and be injected into the interior of the absorption tower 210 through the gas inlet port 25 (see reference numeral 310).

The gas mixture Gm may be injected into the upper part of the second scrubbing space 215a. The gas mixture Gm may move to the lower part of the second scrubbing space 215a (see reference numeral 310).

In some embodiments, the second scrubbing process may be performed in the second scrubbing space 215a.

Specifically, the second scrubbing solution may be supplied through the first shower head 217a (see reference numeral 410). The second scrubbing solution may be water, but the technical idea of the present invention is not limited thereto.

The first shower head 217a may be a spray nozzle, and the first shower head 217a may supply the second scrubbing solution having small particles. As the gas mixture Gm moves to the lower part of the second scrubbing space 215a, the first gas G1 in the gas mixture Gm may be dissolved in the second scrubbing solution. The second scrubbing process may be a process in which the first gas G1 is dissolved in the second scrubbing solution.

The gas mixture Gm may be supplied to the first scrubbing space 225 (see reference numeral 310). The first scrubbing process may be performed in the first scrubbing space 225. The first scrubbing process may be a process in which a first gas G1 of the gas mixture Gm is dissolved in the first scrubbing solution.

While the first scrubbing process is performed, the solution supply nozzle 227 may supply the first scrubbing solution to the upper surface of the third tray 250 (see reference numeral 420). The first scrubbing solution initially supplied may flow downward through the third tray hole 250H, the second tray hole 240H, and the first tray hole 230H. That is, in the initial state, the first scrubbing solution may flow downward through the tray holes 250H, 240H, 230H.

While the first scrubbing process is performed, the gas mixture Gm may rise in the second direction D2. The gas mixture Gm may rise in the second direction D2 by passing through the first tray hole 230H.

Specifically, referring to FIG. 5, the gas mixture Gm may pass through the first tray hole 230H. The bubbles BBL may be formed within the first scrubbing solution SSL. At the contact area where the bubbles BBL and the first scrubbing solution SSL come into contact, the first gas G1 may be dissolved in the first scrubbing solution SSL.

While the first scrubbing process is performed, the first scrubbing solution does not flow downward through the tray holes 250H, 240H, 230H. This may be due to the pressure of the gas mixture Gm rising through the tray holes 250H, 240H, 230H.

During the first scrubbing process, the first scrubbing solution may flow from the upper surface of the third tray 250 toward the third tray wall 255, and may flow over the third tray wall 255 to the upper surface of the second tray 240 (see reference numeral 430). In addition, the first scrubbing solution may flow from the upper surface of the second tray 240 toward the second tray wall 245, and may flow over the second tray wall 245 to the upper surface of the first tray 230 (see reference numeral 440). In addition, the first scrubbing solution may flow from the upper surface of the first tray 230 toward the first tray wall 235, and may flow over the first tray wall 235 to the lower part of the absorption tower 210 (see reference numeral 450).

While the first scrubbing solution flows in the above direction, the gas mixture Gm may pass through the tray holes 250H, 240H, 230H and rise in the second direction D2. As the gas mixture Gm passes through the tray holes 250H, 240H, 230H, the bubbles may be formed within the first scrubbing solution.

Specifically, the gas mixture Gm may pass through the first tray hole 230H (see reference numeral 320). Then, the gas mixture Gm may pass through the second tray hole 240H (see reference numeral 330). Then, the gas mixture Gm may pass through the third tray hole 250H (see reference numeral 340).

As the gas mixture Gm passes through the tray holes 250H, 240H, 230H, the first gas G1 may be dissolved in the first scrubbing solution.

Next, the gas mixture Gm from which the first gas G1 has been removed may pass through the demister 260 and be discharged to the exterior of the absorption tower 210 (see reference numeral 350). The gas mixture Gm discharged through the gas outlet port 26 may have little or no first gas G1 remaining. The gas discharged through the gas outlet port 26 may be the second gas G2.

Although the embodiments of the present invention have been described with reference to the attached drawings, the present invention is not limited to the embodiments described above, but can be manufactured in various different forms, and a person having ordinary skill in the art to which the present invention pertains will understand that the present invention can be implemented in other specific forms without changing the technical idea or essential features of the present invention. Therefore, it should be understood that the embodiments described above are exemplary in all respects and not restrictive.

## Claims

1. A scrubber for semiconductor apparatus scrubbing a gas mixture provided from a semiconductor chamber where a semiconductor process is performed, the scrubber for semiconductor apparatus comprising:
an absorption tower separating the gas mixture into a first gas and a second gas;
a housing defining a first scrubbing space in the absorption tower where a first scrubbing process is performed;
a first tray connected to a first inner side wall of the housing, and extending a first direction intersecting the first inner side wall;
a first tray hole penetrating the first tray in a second direction intersecting the first direction, and through which the gas mixture passes; and
a solution supply nozzle providing a first scrubbing solution for performing the first scrubbing process to an upper surface of the first tray,
wherein the gas mixture passes through the first tray hole and rises in the second direction.

2. The scrubber for semiconductor apparatus of claim 1, wherein the first scrubbing process comprises the gas mixture passing through the first tray hole and rising in the second direction to generate bubbles, and
at a surface where the bubbles come into contact with the first scrubbing solution, at least a portion of the first gas is dissolved into the first scrubbing solution.

3. The scrubber for semiconductor apparatus of claim 1, further comprising:
a first pipe having one end connected to the semiconductor chamber and the other end connected to the absorption tower;
a gas inlet port connected to the first pipe and through which the gas mixture is injected into the interior of the absorption tower;
a gas outlet port connected to the absorption tower and through which the gas mixture is discharged to the exterior of the absorption tower;
a second scrubbing space defined by a first inner side wall of the absorption tower and an outer side wall of the housing facing the first inner side wall of the absorption tower; and
a first shower head installed in an upper part of the second scrubbing space and supplying a second scrubbing solution to the second scrubbing space,
wherein one end of the second scrubbing space is connected to the gas inlet port, and the other end of the second scrubbing space is connected to the first scrubbing space.

4. The scrubber for semiconductor apparatus of claim 3, wherein the gas outlet port is connected to the first scrubbing space, and
wherein a negative pressure is provided to the first scrubbing space through the gas outlet port.

5. The scrubber for semiconductor apparatus of claim 3, wherein the first scrubbing space and the second scrubbing space are connected to each other at a lower part of the absorption tower,
wherein a second scrubbing process is performed in the second scrubbing space, and
wherein the second scrubbing process comprises dissolving at least a portion of the first gas by the second scrubbing solution while the gas mixture is injected into the gas inlet port and flows in the second direction in the second scrubbing space.

6. The scrubber for semiconductor apparatus of claim 3, further comprising:
a third scrubbing space defined by a second inner side wall of the absorption tower intersecting the first inner side wall of the absorption tower and a second outer side wall of the housing facing the second inner side wall of the absorption tower; and
a second shower head installed in an upper part of the third scrubbing space and supplying a third scrubbing solution to the third scrubbing space.

7. The scrubber for semiconductor apparatus of claim 6, further comprising:
a fourth scrubbing space defined by a third inner side wall of the absorption tower and a third outer side wall of the housing facing the third inner side wall of the absorption tower; and
a third shower head installed in an upper part of the fourth scrubbing space and supplying a fourth scrubbing solution to the third scrubbing space,
wherein the first inner side wall of the absorption tower connects the second inner side wall of the absorption tower and the third inner side wall of the absorption tower to each other.

8. The scrubber for semiconductor apparatus of claim 1, further comprising:
a second tray connected to a second inner side wall of the housing, extending in the first direction, and spaced apart from the first tray in the second direction; and
a second tray hole penetrating the second tray in the second direction, and through which the gas mixture passes,
wherein the second inner side wall of the housing faces the first inner side wall of the housing, and
wherein the gas mixture rises by passing through the second tray hole.

9. The scrubber for semiconductor apparatus of claim 1, further comprising:
a first tray wall connected to one end of the first tray and protruding in the second direction from an upper surface of the first tray and a lower surface of the first tray,
wherein the first tray wall comprises a first portion protruding from the upper surface of the first tray, and
wherein the first scrubbing solution flows from the upper surface of the first tray to the protruding portion, and flows toward a lower part of the absorption tower over the protruding portion.

10. The scrubber for semiconductor apparatus of claim 1, wherein at least a portion of the first gas is dissolved in the first scrubbing solution, and
wherein the first gas contains a hydrophilic gas.
